Europäisches Patentamt

European Patent Office

Office européen des brevets

(11) Publication number: **0 327 123 B1**

# EUROPEAN PATENT SPECIFICATION

(45) Date of publication of patent specification: **28.07.93**　(51) Int. Cl.⁵: **G01R 33/035**

(21) Application number: **89101953.1**

(22) Date of filing: **03.02.89**

(54) **Superconducting quantum interference device.**

(30) Priority: **05.02.88 JP 23669/88**

(43) Date of publication of application:
**09.08.89 Bulletin 89/32**

(45) Publication of the grant of the patent:
**28.07.93 Bulletin 93/30**

(84) Designated Contracting States:
**DE FR GB**

(56) References cited:
**EP-A- 0 246 419**

**IEEE TRANSACTIONS ON MAGNETICS, vol.
MAG-23, no. 2, March 1987, pages 1650-1657,
IEEE, New York, US; M.B. KETCHEN:
"Integrated thin-film dc squid sensors"**

**APPLIED PHYSICS LETTERS, vol. 51, no. 3,
20th July 1987, pages 200-202, American In-
stitute of Physics; R.H. KOCH et al.:
"Ouantum interference devices made from
superconducting oxide thin films"**

(73) Proprietor: **HITACHI, LTD.**
**6, Kanda Surugadai 4-chome**
**Chiyoda-ku, Tokyo 100(JP)**

(72) Inventor: **Nakane, Hideaki**
**617-152, Yokokawamachi**
**Hachioji-shi(JP)**
Inventor: **Tarutani, Yoshinobu**
**599-11, Matsudome Uenoharamachi**
**Kitatsuru-gun Yamanashi-ken(JP)**

(74) Representative: **Strehl, Schübel-Hopf, Groen-
ing**
**Maximilianstrasse 54 Postfach 22 14 55**
**W-8000 München 22 (DE)**

## Description

## BACKGROUND OF THE INVENTION

The present invention relates to a superconducting quantum interference device (hereinbelow abbreviated to SQUID) suitable for detecting very weak magnetic flux, and in particular to a SQUID utilizing high temperature superconductor.

The SQUID is a magnetic fluxmeter having the highest sensitivity, utilizing the quantum interference effect, which electrons in the superconductive state have. For this reason, SQUIDs are used as devices for measuring very weak magnetic field, e.g. for measurement of magnetic field in a living body, measurement of terrestrial magnetism, search of underground resources, etc.

The SQUID has an excellent performance as a fluxmeter. However, since the operating temperature of a Josephson element is restricted by the critical temperature of the superconductor, the SQUID using a prior art superconductor made of metal such as Nb, etc. was used at the liquid helium temperature (boiling point: absolut temperature 4.2 K). However, since liquid helium is expensive and further because of problems concerning cryogenic techniques, there existed restrictions in its application field. Recently, owing to the discovery and development of oxide high temperature superconductors the application of the SQUID has entered a new stage. Attention has been paid to SQUIDs using liquid nitrogen (boiling point: absolute temperature 77K) which is cheap and used widely as cooling medium, which has been realized by using an oxide high temperature superconductor. However, since the operating temperature of the SQUID using an oxide high temperature superconductor is 77K, which is about 20 times as high as the operating temperature of the prior art SQUID, which is 4.2K, there exist technical problems, which are to be solved.

A SQUID using a high temperature superconductor thin film is disclosed in an article published in APPl. Phys. Lett., 51, (1987) pp 200-202. Although some examples on the SQUID using a high temperature superconductor thin film have been published, it has been not yet realized to study technical problems for the purpose of practical use and to find solutions therefor.

## [SUMMARY OF THE INVENTION]

The object of the present invention is to provide a SQUID using a high temperature superconductor.

Among the technical problems to be solved for realizing a SQUID using a high temperature superconductor thin film there is a problem concerning thermal noise. Concerning thermal noise, following equations are valid:

thermal noise voltage $\sqrt{|V_N|^2} = 2 k_B TRB$ (1)

thermal noise current $\sqrt{|I_N|^2} = 2 k_b TgB$ (2)

where

| | |
|---|---|
| $k_B$: | Boltzmann's constant, |
| T: | absolute temperature (K), |
| R: | resistance, |
| B: | frequency band width of a relevant signal, |
| and $g = \frac{1}{R}$: | conductance. |

As it can be understood from Eqs. (1) and (2), the thermal noise varies with respect to the temperature. Consequently it is increased necessarily by the fact that the operating temperature of the SQUID changes from the liquid helium temperature (4.2K) to the liquid nitrogen temperature (77K). That is, it gives rise to a problem concerning thermal noise produced in a resistor to use a high temperature superconductor in the SQUID. This thermal noise hides voltage signals in the SQUID and at the same time decreases the critical current for the superconductor, which reduces further the voltage signals. For this reason, it is necessary to set the signal level in the SQUID in such a manner that the thermal noise produced in the resistor doesn't obstruct measurements. The object of the present invention is to study the structure of the SQUID and the thermal noise produced in the resistor and to set signal values to such a level that the thermal noise gives rise to problems in order to provide a SQUID using a high temperature superconductor, which is usable in practice.

In a SQUID using a high temperature superconductor, since it is used at the liquid nitrogen temperature (77K) contrarily to the fact that a prior art SQUID is used at the liquid helium temperature (4.2K), thermal noise increases, as described previously. Together therewith, it becomes necessary to set signal detection voltage values at a level higher than that of the thermal noise. For this reason it is necessary to increase the intensity $I_c$ of the current flowing through a Josephson junction in the SQUID. By the prior art SQUID operating at the liquid helium temperature 4.2K, even with a critical current $I_m$ flowing through the Josephson junction, which is as low as about 10 $\mu$A, it is possible to detect signal voltages overcoming voltages due to the thermal noise. However, when the SQUID using a high temperature superconductor operates at the liquid nitrogen temperature 77K, in order to be able to detect signal voltages, overcoming the thermal noise, it is necessary to increase the critical current $I_m$ flowing through the Josephson junction to about 100 $\mu$A, which is 10 times as high as that required for the preceding case.

On the other hand, among the inductance L of the SQUID, the critical current $I_m$ flowing through the Josephson junction, and the fluxoid quantum $\Phi_0$, the following relation is valid:

$$LI_m \simeq \Phi_0 = \frac{h}{2e} = 2.07 \times 10^{-15} \text{ (Wb)} \qquad (3)$$

Consequently, when the critical current $I_m$ flowing through the Josephson junction is increased, it is necessary to reduce the inductance L of the SQUID. Concretely speaking, supposing that the SQUID inductance, with which a desired output current can be obtained with respect to the thermal noise, when the SQUID operates at the liquid helium temperature 4.2K, is 100-400 pH, the SQUID inductance, with which a desired output current can be obtained with respect to the thermal noise, when it operates at the liquid nitrogen temperature 77K, is 10-40 pH, which is one tenth time as low as the preceding value.

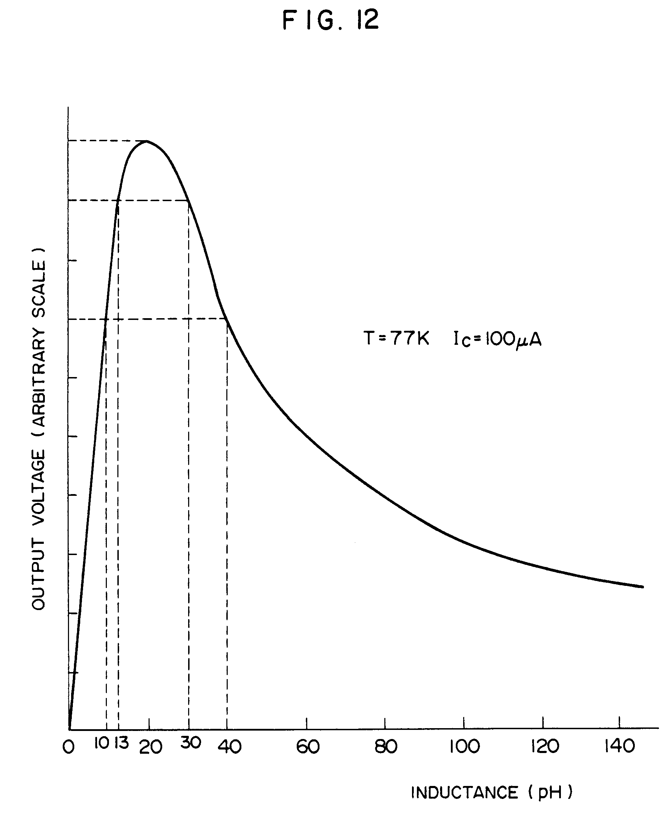

Fig. 12 indicates the relation between the SQUID inductance and the output voltage, when the current flowing through a Josephson junction $I_c$ = 100 $\mu$A, the SQUID operating at 77K.

The present invention, based on the consideration described above, is characterized in that the SQUID inductance is chosen so as to be in a range between 10 and 40 pH, and more preferably in a range between 13 and 30 pH, as indicated in Fig. 12.

As concrete methods for reducing the inductance of the SQUID, following measures are taken in the embodiments, which constitute the content of the present invention;

(1) the aperture of the SQUID is reduced;

(2) inductances of a plurality of SQUIDs are connected in parallel;

(3) a superconductive ground plane is used; etc.

Now a concrete structure of a SQUID according to the present invention will be explained.

In a SQUID using a high temperature superconductor it is possible to set the signal voltage of the SQUID at a level higher than that of the thermal noise voltage and to make the SQUID operate with a high efficiency at the liquid nitrogen temperature by reducing the inductance of the SQUID by the methods (1) to (3) described above.

According to the present invention, it is possible to realize the optimum structure for making a SQUID using a high temperature superconductor operate at the temperature of liquid nitrogen of low price and practical use of the SQUID using a high temperature superconductor in a wide application field.

BRIEF DESCRIPTION OF THE DRAWINGS

Fig. 1A is a scheme illustrating a SQUID in an embodiment of the present invention;

Fig. 1B is a circuit diagram of the SQUID in the embodiment of the present invention;

Fig. 1C is a scheme for explaining a periodical voltage generated in the SQUID in the embodiment of the present invention;

Fig. 2 is a scheme illustrating a SQUID in another embodiment of the present invention;

Fig. 3 is a scheme illustrating a SQUID, in which SQUID inductances are connected in parallel, in still another embodiment of the present invention;

Fig. 4 is a plan view of the SQUID indicated in Fig. 3;

Fig. 5 is a plan view of the SQUID, in which SQUID inductances are connected in parallel, in still another embodiment;

Fig. 6A is a plan view of an S-shaped SQUID in still another embodiment of the present invention;

Fig. 6B is a scheme for explaining the SQUID indicated in Fig. 6B;

Fig. 7 is a plan view of a SQUID, in which SQUID inductances are connected in parallel, in still another embodiment of the present invention;

Fig. 8 is a scheme illustrating a SQUID, in which a superconducting ground plane is used, in still another embodiment of the present embodiment;

Fig. 9 is a plan view of a SQUID, in which 4 SQUID inductances are connected in parallel, in still another embodiment of the present invention;

Fig. 10 is a scheme illustrating a SQUID, in which 4 SQUID inductances are connected in parallel, in still another embodiment of the present invention;

Fig. 11 is a scheme of a SQUID, in which 2 substrates are used, in still another embodiment of the present invention; and

Fig. 12 is a graph indicating the relation between the SQUID inductance and the output voltage at T = 77K (current flowing through a Josephson junction $I_c$ = 100 $\mu$A).

DESCRIPTION OF THE PREFERRED EMBODIMENT

Hereinbelow the preferred embodiments of the present invention will be explained, referring to the drawings.

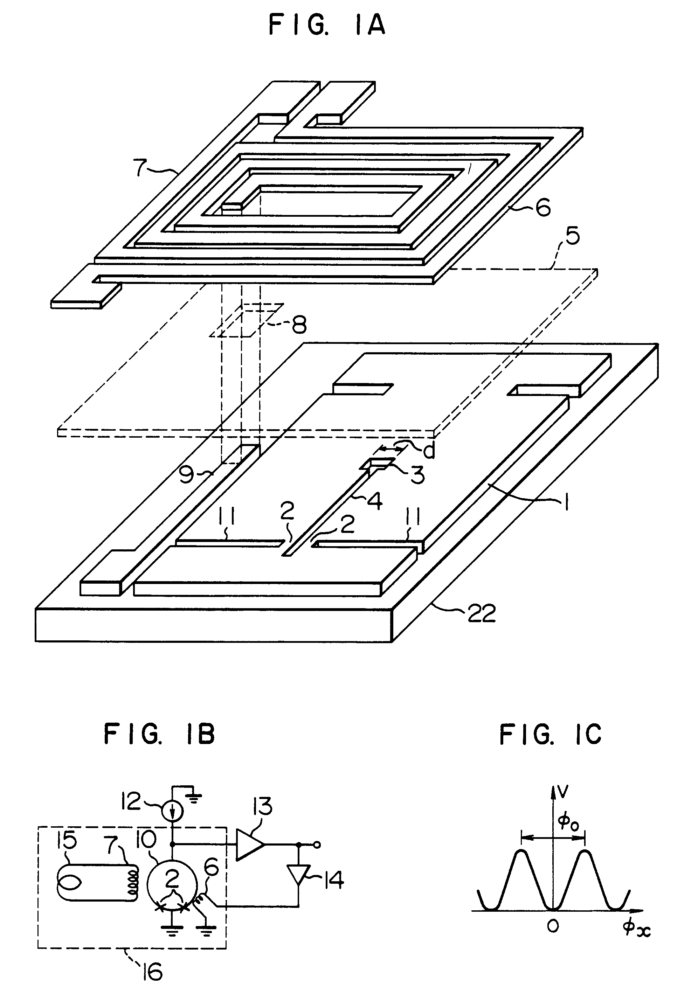

Fig. 1A is a scheme illustrating an example of an embodiment of the present invention.

In the SQUID indicated in Fig. 1A a washer-shaped inductance is used as a SQUID inductance. In the washer-shaped coil, since an aperture portion, in which the magnetic flux is coupled, and the Josephson junction can be separated far from each other, the inductance due to the deep cut off in the Josephson junction can be removed from the SQUID inductance.

In the SQUID indicated in Fig. 1A a first high temperature superconductor layer 1 is formed on a substrate 22. Then an aperture portion 3 and a slit 4, where the magnetic flux is coupled, which constitute the SQUID inductance, are formed by processing the first high temperature superconductor layer 1. Further there are disposed deeply cut off portions 11 on both the sides of the slit 4 at the end portion thereof to form Josephson junctions 2. Since microbridge type Josephson junctions are used often in connection with the coherence length of the crystalline grain boundary in the high temperature superconductor, the present invention will be explained below, taking the microbridge type junction as an example.

A first interlayer insulating layer 5 is formed on this first superconductor layer 1. Further a modulation coil 6 and an input coil 7 are formed by processing a second high temperature superconductor layer thereon. One end of the input coil 7 is taken out by a lower connection electrode 9 through a contact hole formed in the first interlayer insulating layer 5. Fig. 1B shows an example of the circuit, in the case where the SQUID is operated as a fluxmeter. A constant current power supply 12, a sensor coil 15 and a phase detector amplifier 13 are connected with the SQUID 10. Fig. 1C shows a periodically voltage generated, when the SQUID 10 is biased with a constant current and a magnetic flux is applied thereto. Since the period of this voltage is a very small value corresponding to the fluxoid quantum $\Phi_0$ (2.07 x $10^{-15}$ Wb), a high sensitivity magnetic field measurement is made possible by means of a SQUID. In the circuit indicated in Fig. 1B variations in voltage with respect to variations in magnetic flux are detected by the phase detector amplifier 13 and fed back to the modulation coil 6 in the SQUID 10 through a feedback circuit 14. In this way, the operating point of the SQUID 10 being fixed, it is possible to read out electrically variations therefrom as variations in the fed back signal. By means of this circuit it is possible to detect one thousandth to one ten thousandth of the fluxoid quantum $\Phi_0$. The SQUID 10 and the sensor coil are located in a low temperature section 16. The high temperature superconductor is made of a mixture of some of oxides of potassium K, calcium Ca, cesium Cs, scandium Sc, strontium Sr, yttrium Y, rare earth elements, barium Ba, copper Cu, thallium Tl, lead Pb, and bismuth

Bi. For example $YBa_2Cu_3O_{7-x}$ for which $T_c$ = 90K, $Bi_aSr_bCa_cCu_dO_x$ for which $T_c$ = 100K, $Tl_aSr_bCa_cCu_dO_x$ for which $T_c$ = 120K, etc. are used therefor. Since this SQUID fluxmeter utilizes a high temperature superconductor, it can be used at the neighborhood of the liquid nitrogen temperature 77K. An insulating substrate is used as th substrate 22. As the concrete material therefor magnesium oxide MgO, strontium titanate $SrTiO_3$, etc. are used. It is tried also to use Si or $SiO_2$ for the substrate 22.

As explained in the item of "Summary of the Invention, in the case where a SQUID using a high temperature superconductor is operated at the liquid nitrogen temperature, the SQUID inductance should be chosen in a range between 10 and 40 pH and more preferably between 13 and 30 pH. In the case where the aperture 3 of the SQUID is quadratic, between the length of the side and the SQUID inductance the following relationship is valid;

$$L = 1.25\,\mu_0 d \quad (4)$$

where d represents the length of one side of the aperture. In the SQUID having the structure indicated in Fig. 1A, in order to realize the SQUID inductance described above, the length d of one side of the aperture should be chosen in a range between 6.4 and 25.5 $\mu$m and more preferably between 8.3 and 19.1 $\mu$m. Although explanation has been made for the case where the aperture is quadratic, the size thereof can be determined for other shapes by a method similar thereto. For example, for a circular aperture, the size thereof can be determined by a relationship $L = \mu_0 D$ (D representing the diameter of the aperture).

Furthermore, in this embodiment, the SQUID is constructed by superposing the first high temperature superconductor layer and the second high temperature superconductor layer (forming the modulation coil, etc.) on each other in the form of a double layer as the high temperature superconductor layer. In this embodiment the connection electrode 9 and the first high temperature superconductor layer 1 for the SQUID are located on the same plane so that a SQUID element having the simplest structure is realized. In the SQUID in the embodiment indicated in Fig. 1A the superconductor layer 1 is about 1 $\mu$m thick; the interlayer insulating layer 5 is about 1.2 $\mu$m thick; and the modulation coil is about 1.4 $\mu$m thick. From the reason of the fabrication, among the first superconductor layer 1, the interlayer insulating layer 5 and the modulation coil 6 obtained by processing the second superconductor layer, a higher superposed layer is somewhat thicker than a lower layer.

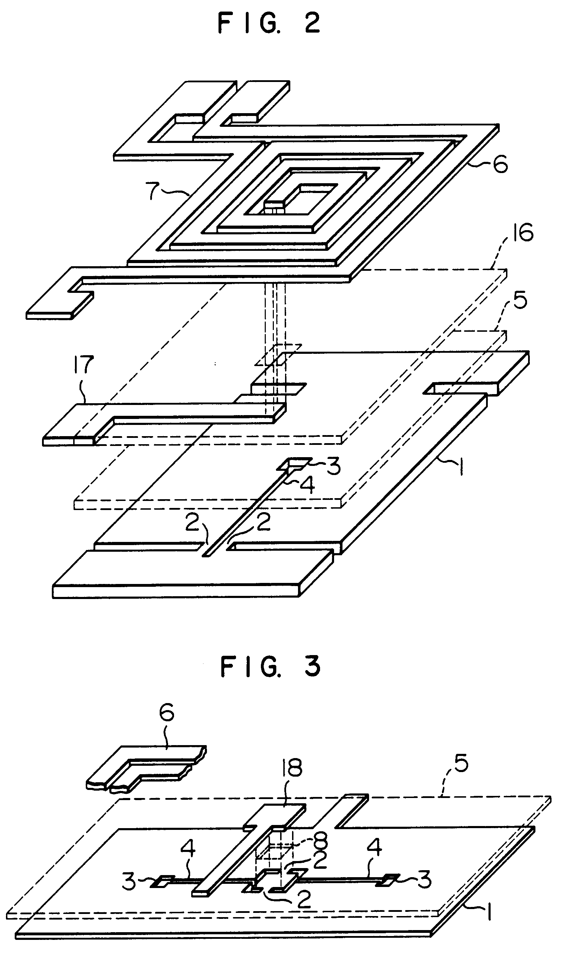

Fig. 2 is a scheme of an embodiment, in which the SQUID comprises 3 high temperature superconductor layers. An aperture portion 3 and a slit 4 are formed by processing a first high temperature superconductor layer 1, which constitute a SQUID inductance. Further two Josephson junction 2 are disposed. An interlayer insulating layer 5 is formed thereon and further a connection electrode 17 and an interlayer insulating layer 16 are superposed thereon. Finally a modulation coil 6 and an input coil 7 are formed to construct the SQUID. In such a structure a constant bias current is made flow through the SQUID inductance, which is the first layer; a small signal is applied to the input coil 7, which is a combination of the second and third layers; further a feedback signal is applied to the modulation coil 6; and thus a very weak magnetic flux is detected. In this embodiment, since the whole input coil 7 is superposed on the SQUID inductance, an effect can be obtained that the coupling coefficient between the input coil 7 and the SQUID inductance is great.

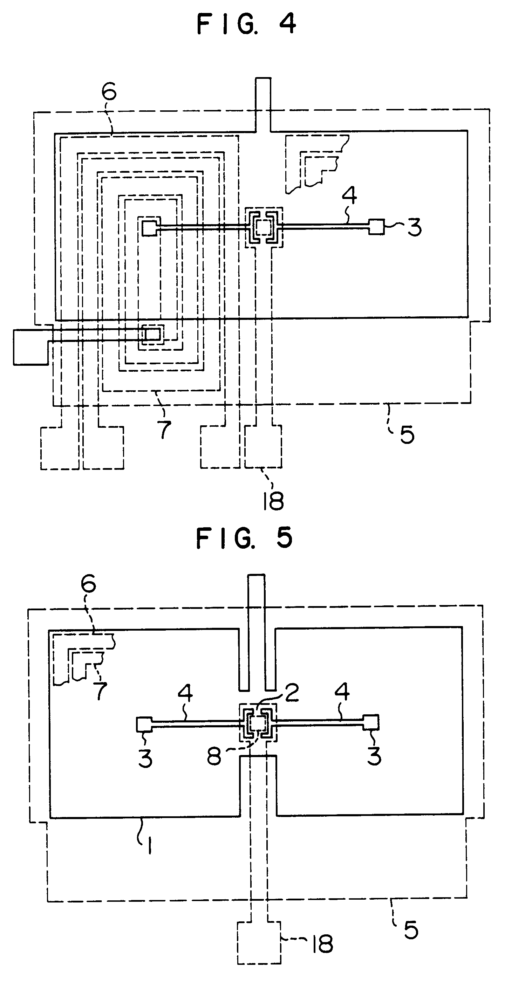

Fig. 3 and 4 are a scheme and a plan view illustrating an embodiment, in which a SQUID is constructed by using 2 high temperature superconductor layers. They show the structure of lower layers, removing a part of the input coil 7 and the modulation coil 6. Two sets of apertures 3 and slits 4 are formed by processing the high temperature superconductor layer 1. Two Josephson junction 2 are formed at the central portion and a connection electrode 18 is connected through a contact hole 8 after having insulated them by means of an interlayer insulating layer 5. In this way two of the SQUID inductances used in Figs. 1 and 2 are connected in parallel and thus the inductance is reduced to a half. For this reason, even if the current flowing through the Josephson junctions, it can be set in the optimum operating range ($L \cdot I_m \sim \Phi_0$) for the SQUID and thus an effect that the output voltage is high can be obtained. Further, if $I_m$ can be great at the high temperature operation, another effect can be obtained that erroneous operation due to thermal noise is prevented. Further, since the coupling portion of the input coil 6 is doubled, there is still another effect that the coupling, when an input signal is applied to the SQUID, is great. In this way it is possible to reduce the superconducting inductance by the parallel connection, while keeping the aperture portion larger than that of the single connection.

Fig. 5 is a plan view of an embodiment, in which a SQUID is constructed by using two high temperature superconductor layers. Two sets of apertures 3 and slits 4 are formed by processing the high temperature superconductor layer 1. Two Josephson elements are formed at the central portion and a connection electrode 18 is connected through a contact hole 8 after having insulated them by means of an interlayer insulating layer 5. In this embodiment, since the electrode in the neighborhood of the connection electrode 18 is small, an effect that the stray capacitance is small. Further, in the embodiments illustrated in Figs. 3 and 5, two SQUID inductances are connected in parallel. However, evan if more than two inductances are connected in parallel, a similar effect can be obtained. Further, even if a three-layered superconductor layer is used, as indicated in Fig. 2, a similar effect can be obtained.

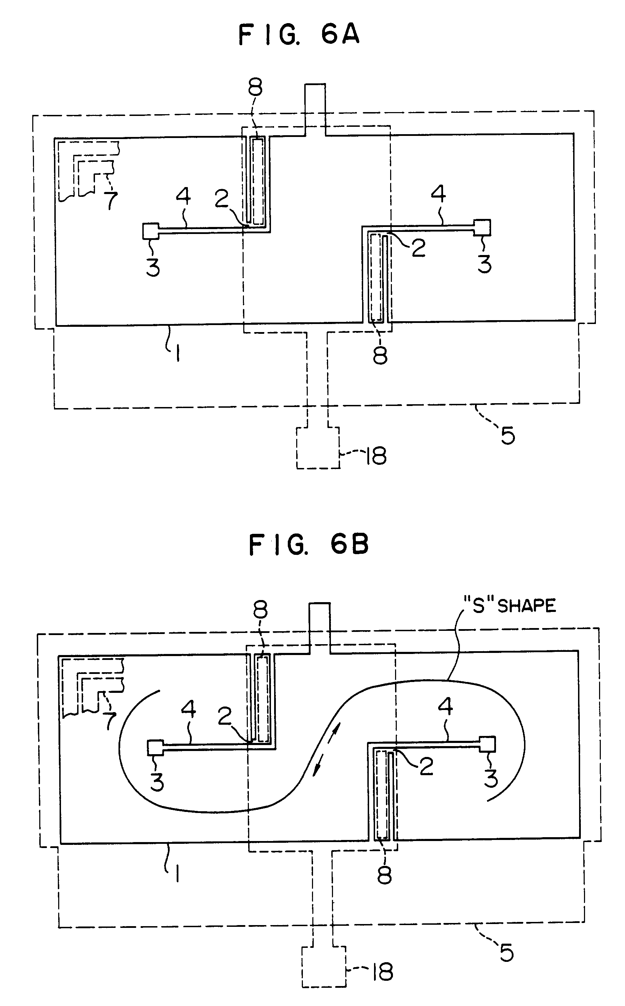

Fig. 6A is a plan view of an embodiment, in which a SQUID is constructed by using two high temperature superconductor layers. Two sets of apertures 3 and slits 4 are formed by processing the high temperature superconductor layer 1. A Josephson junction 2 is formed at the extremity portion of each of the slits 4 and a connection electrode 18 is connected through contract holes 8 after having insulated them by means of an interlayer insulating layer 5. Although the inductance is reduced to a half in this embodiment, too, by connecting SQUID inductances in parallel, the difference thereof from the embodiment indicated in Figs. 4 and 5 consists in that the slits 4 are formed in an L-shaped and that the superconductor layer 1 is S-shaped, as indicated in Fig. 6B. Since the superconductor layer 1 is S-shaped, the currents at the places where the magnetic flux is coupled with the two right and left SQUID inductances are compensated, as indicated by arrows. In this way an effect can be obtained that it is possible to nullify magnetic flux noise coming from the exterior. In this case, the input coils 7 are directed opposite to each other so that the signals from the input coils are not compensated. In this embodiment, too, the SQUID inductance can be reduced and an effect that the optimum operating range can be set is obtained.

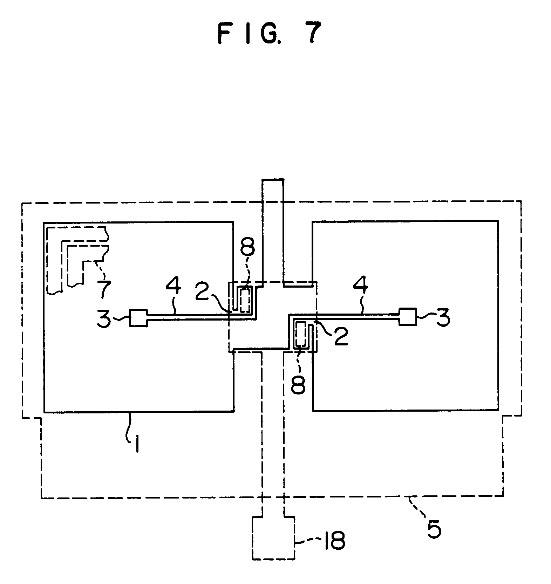

Fig. 7 is a plan view of an embodiment, in which a SQUID is constructed by using a two high temperature superconductor layers. Two sets of apertures 3 and slits 4 are formed by processing the high temperature superconductor layer 1 and 2 SQUID inductances are connected in parallel so that the value of the inductance is reduced to a half and the optimum operating range is set. Further the left and right SQUID inductances are directed opposite to each other so that the magnetic flux noises coupled therewith are compensated. In this way, apart from the effects that the optimum operating range can be set and that the magnetic flux noises are compensated, an effect that the stray capacitance is reduced by making the electrode at the neighborhood of the connection electrode 18 smaller.

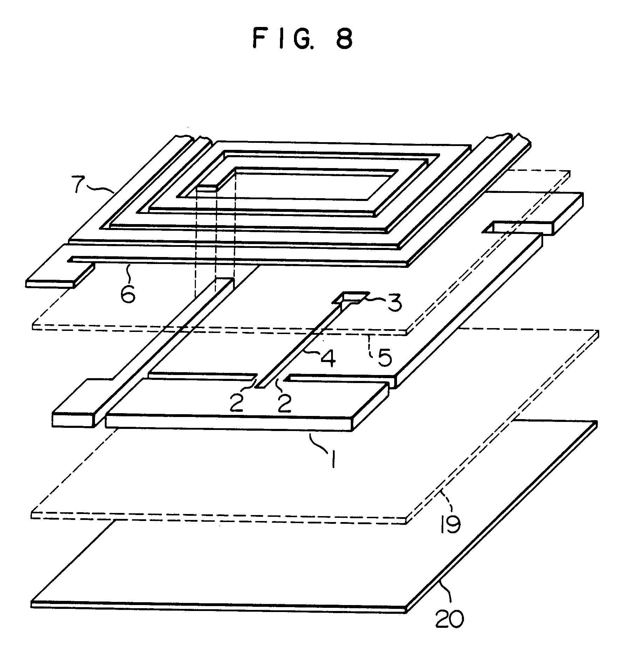

Fig. 8 is a scheme illustrating still another embodiment, in which a SQUID is constructed by using three high temperature superconductor layers. A high temperature superconductor layer serves as a superconducting ground plane. After having insulated it by means of an interlayer insulating layer 19, an aperture portion 3 and a slit 4 are formed by processing another high temperature layer 1, which constitute a SQUID inductance and two Josephson junctions 2 are disposed. After having formed an interlayer insulating layer 5 thereon to insulate them, an input coil 7 and a modulation coil 6 are formed to constitute the SQUID. In this embodiment, since the SQUID inductance is superposed on the superconducting ground plane, an effect is obtained that the inductance is reduced and the optimum operating range of the SQUID can be realized.

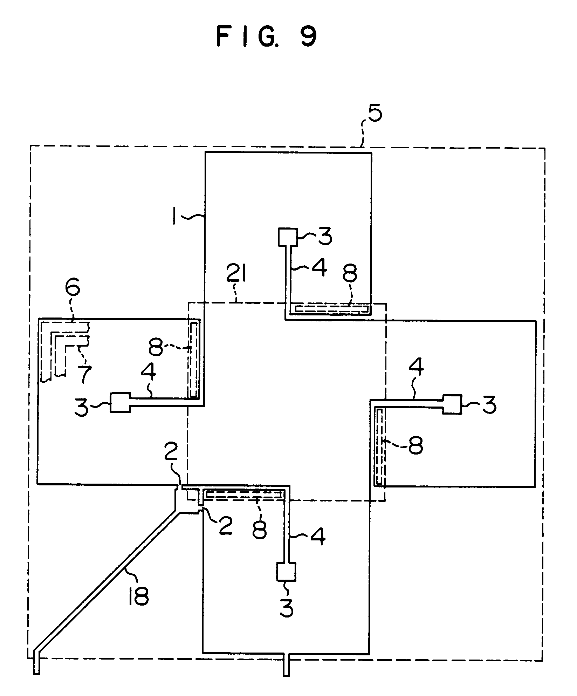

Fig. 9 is a plan view of a still another embodiment, in which a SQUID is constructed by using two high temperature superconductor layers. Four sets of aperture portions 3 and slits 4 are formed by processing the high temperature superconductor layer 1 and 4 SQUID inductances are connected in parallel so that the value of the inductance is reduced to a quarter and the SQUID is set in the optimum operating range. Further these SQUID inductances are directed differently so that magnetic flux noises coupled therewith are compensated. In this way an effect that the optimum operating range can be set and the output voltage is high is obtained. In addition, there is another effect that the SQUID thus constructed is hardly influenced by external magnetic flux noise.

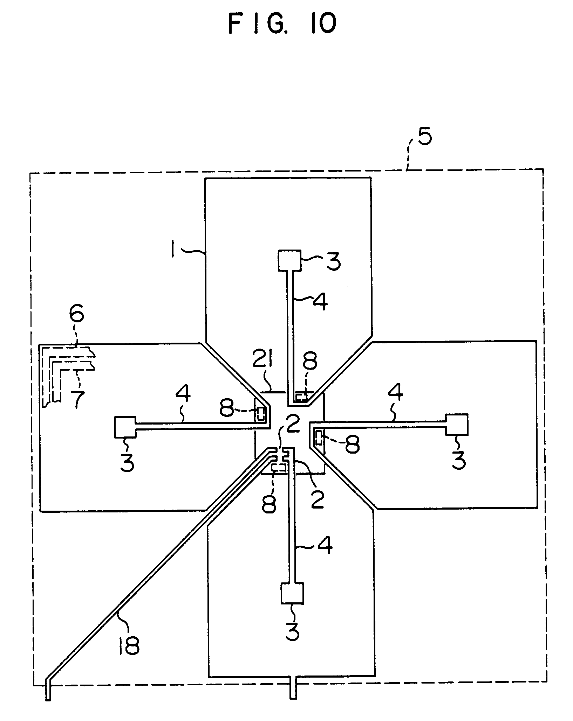

Fig. 10 is a plan view of still another embodiment, in which a SQUID is constructed by using two high temperature superconductor layers. Four sets of aperture portions 3 and slits 4 by processing the high temperature superconductor layers 1 and 4 SQUID inductances are connected in parallel so that the value of the inductance is reduced to a quarter and the SQUID is set in the optimum operating range. Further these SQUID inductances are so combined that magnetic flux noises coupled therewith are compensated. Further the area of the connection electrode 21, which is in the second layer, is made small to reduce stray capacitance. In this way an effect is obtained that the inductance is reduced and the SQUID can be set in the optimum operating range so that a high output voltage is obtained and there is another effect that the S/N ratio can be improved, because magnetic flux noises are compensated. Furthermore, since the stray capacitance is reduced, there is still another effect that the operating frequency band is enlarged or the output voltage is increased. Equivalent effects can be expected, if more than two inductances are connected in parallel.

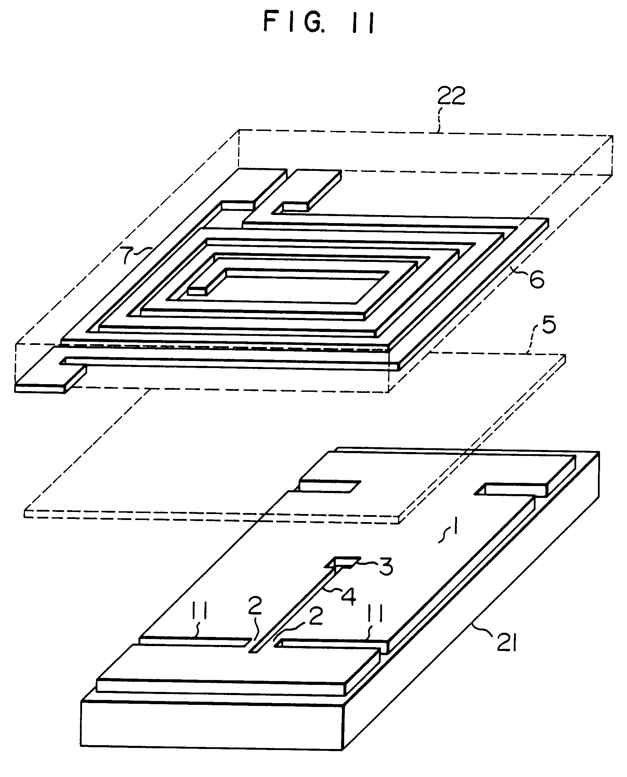

Fig. 11 is a scheme of still another embodiment, in which a SQUID is constructed by using two substrates, each of which is provided with a high temperature superconductor layer. An aperture portion 3 and a slit 4 are formed by processing a high temperature superconductor layer 1 disposed on the substrate 21. On the other hand another high temperature superconductor layer is formed on the other substrate and a modulation coil 6 and an input coil are formed by processing it. These two substrates are closely stuck through an interlayer insulating layer to form a SQUID. The interlayer insulating layer 5 may be formed on either one of the substrates. In this way an effect can be obtained that the SQUID using high temperature superconductor layers is constructed in a simple manner.

The Josephson junction used in the above embodiments may be a bridge type junction, in which the stripe width or the layer thickness of the superconductor layers is small, a sandwich type junction or a procimity effect type junction.

According to the present invention it is possible to realize a SQUID of excellent characteristics by setting the SQUID inductance at the optimum value to set the signal voltage value at a level sufficiently higher than the thermal noise level in a SQUID using a high temperature superconductor. According to the present invention the SQUID can be operated at the liquid nitrogen temperature and therefore very weak magnetic field measurement such as living body magnetism measurement, etc. is facilitated.

**Claims**

1.  A superconducting quantum interference device (SQUID) comprising:

    at least a substrate (21, 22);

    a first high temperature superconductor layer (1) for superconducting inductance formed on said substrate (21, 22) and having at least an aperture (3), at least a slit (4) extending from said aperture (3) into the surrounding thereof and two Josephson junctions (2) disposed on both the sides of said slit (4);

    a first interlayer insulating layer (5) formed On said first high temperature superconductor layer (1); and

    a modulation coil (6) and an input coil (7) formed by processing a second high temperature superconductor layer for wiring formed on said first insulating layer (5);

    wherein the value of the superconducting inductance is chosen in a range between 10 and 40 pH.

2. A superconducting quantum interference device (SQUID) according to Claim 1, wherein the value of the superconducting inductance is chosen in a range between 13 and 30 pH.

3. A superconducting quantum interference device (SQUID) according to Claim 1, wherein said first high temperature superconductor layer (1) has at least a square aperture (3) and the length of one side of said aperture is chosen in a range between 6.4 $\mu$m and 25.5 $\mu$m.

4. A superconducting quantum interference device (SQUID) according to Claim 1, wherein said first high temperature superconductor layer (1) has n (n $\geq$ 2) apertures (3), a slit (4) extending from each of said apertures (3) and two Josephson junctions (2) disposed on both the sides of said slit (4), superconducting inductances of said junctions being connected in parallel.

5. A superconducting quantum interference device (SQUID) according to Claim 4, wherein stray capacitance is reduced by reducing the area of the part in the neighborhood of an electrode, which is opposite to said Josephson junctions (2).

6. A superconducting quantum interference device (SQUID) according to Claim 4, wherein there are disposed n = 2 apertures and 2 superconducting inductances are connected in parallel.

7. A superconducting quantum interference device (SQUID) according to Claim 4, wherein there are disposed n = 4 apertures and 4 superconducting inductances are connected in parallel.

8. A superconducting quantum interference device (SQUID) according to Claim 6, wherein the superconducting inductance is S-shaped.

9. A superconducting quantum interference device (SQUID) according to Claim 7, wherein the superconducting inductance intersects an S-shape at a right angle.

10. A superconducting quantum interference device (SQUID) according to Claim 1, wherein connection electrodes (9) and said first high temperature superconductor layer (1) are formed on the same plane.

11. A superconducting quantum interference device (SQUID) according to Claim 1, wherein apart from said first high temperature superconductor layer (1), said first insulating layer (5) and said second high temperature superconductor layer, at least another high temperature superconductor layer and at least another interlayer insulating layer are superposed on each other and terminals of said input coil (7) are taken out.

12. A superconducting quantum interference device (SQUID) according to Claim 1, wherein apart from said first high temperature superconductor layer (1), said first insulating layer (5) and said second high temperature superconductor layer, at least another high temperature superconductor layer (20) and at least another inter layer insulating layer are superposed on each other and a ground plane is disposed.

13. A superconducting quantum interference device (SQUID) according to Claim 1, wherein it comprises two substrates (22), on one of which said first high temperature superconductor layer (1) having the aperture (3) and the slit (4) is formed and on the other of which said second high temperature superconductor layer are superposed, said modulation coil (6) and said input coil (7) being formed therefrom, said two substrates (21, 22) being stuck closely through said first insulating layer (5) put therebetween.

14. A superconducting quantum interference device (SQUID) according to Claim 1, wherein said high temperature superconductor layers (1, 6, 7, 20) are made of a mixture of some of oxides of potassium K, calcium Ca, cesium Cs, Scandium Sc, strontium Sr, yttrium Y, rare earth elements, barium Ba, copper Cu, thallium Tl, lead Pb, and bismuth Bi.

**Patentansprüche**

1. Supraleitende Quanteninterferenzanordnung (SQUID), umfassend
   mindestens ein Substrat (21, 22),
   eine auf dem Substrat (21, 22) ausgebildete erste Hochtemperatur-Supraleiterschicht (1) für eine Supraleiter-Induktanz mit mindestens einer Öffnung (3), mindestens einem von der Öffnung (3) ausgehenden und in deren Umgebung verlaufenden Schlitz (4) und zwei zu beiden Seiten des Schlitzes (4) angeordneten Josephson-Übergängen (2),
   eine auf der ersten Hochtemperatur-Supraleiterschicht (1) ausgebildete erste Zwischenlagen-Isolierschicht (5), und

eine Modulationsspule (6) und eine Eingangsspule (7), die durch Bearbeiten einer auf der ersten Isolierschicht (5) angeordneten zweiten Hochtemperatur-Supraleiterschicht für Verdrahtung erzeugt sind,

wobei die Größe der Supraleiter-Induktanz im Bereich zwischen 10 und 40 pH gewählt ist.

2. Supraleitende Quanteninterferenzanordnung (SQUID) nach Anspruch 1, wobei die Größe der Supraleiter-Induktanz in einem Bereich zwischen 10 und 30 pH gewählt ist.

3. Supraleitende Quanteninterferenzanordnung (SQUID) nach Anspruch 1, wobei die erste Hochtemperatur-Supraleiterschicht (1) mindestens eine quadratische Öffnung (3) aufweist und die Seitenlänge dieser Öffnung in einem Bereich zwischen 6,4 und 25,5 $\mu$m gewählt ist.

4. Supraleitende Quanteninterferenzanordnung (SQUID) nach Anspruch 1, wobei die erste Hochtemperatur-Supraleiterschicht (1) n (n $\geq$ 2) Öffnungen (3), einen von jeder dieser Öffnungen (3) ausgehenden Schlitz (4) und zwei zu beiden Seiten des Schlitzes (4) angeordnete Josephson-Übergänge (2) aufweist, und wobei die Supraleiter-Induktanzen der Übergänge parallel geschaltet sind.

5. Supraleitende Quanteninterferenzanordnung (SQUID) nach Anspruch 4, wobei Streukapazität durch Verringerung der Fläche des den Josephson-Übergängen (2) gegenüberliegenden Teils in der Nähe einer Elektrode verringert ist.

6. Supraleitende Quanteninterferenzanordnung (SQUID) nach Anspruch 4, wobei n = 2 Öffnungen vorgesehen und 2 Supraleiter-Induktanzen parallel geschaltet sind.

7. Supraleitende Quanteninterferenzanordnung (SQUID) nach Anspruch 4, wobei n = 4 Öffnungen vorgesehen und 4 Supraleiter-Induktanzen parallel geschaltet sind.

8. Supraleitende Quanteninterferenzanordnung (SQUID) nach Anspruch 6, wobei die Supraleiter-Induktanz S-förmig ist.

9. Supraleitende Quanteninterferenzanordnung (SQUID) nach Anspruch 7, wobei die Supraleiter-Induktanz eine S-Form rechtwinklig schneidet.

10. Supraleitende Quanteninterferenzanordnung (SQUID) nach Anspruch 1, wobei Anschlußelektroden (9) und die erste Hochtemperatur-Supraleiterschicht (1) in derselben Ebene ausgebildet sind.

11. Supraleitende Quanteninterferenzanordnung (SQUID) nach Anspruch 1, wobei außer der ersten Hochtemperatur-Supraleiterschicht (1), der ersten Isolierschicht (5) und der zweiten Hochtemperatur-Supraleiterschicht mindestens eine weitere Hochtemperatur-Supraleiterschicht und mindestens eine weitere Zwischenlagen-Isolierschicht aufeinander angeordnet und Anschlüsse der Eingangsspule (7) herausgeführt sind.

12. Supraleitende Quanteninterferenzanordnung (SQUID) nach Anspruch 1, wobei außer der ersten Hochtemperatur-Supraleiterschicht (1), der ersten Isolierschicht (5) und der zweiten Hochtemperatur-Supraleiterschicht mindestens eine weitere Hochtemperatur-Supraleiterschicht (20) und mindestens eine weitere Zwischenlagen-Isolierschicht übereinander angeordnet sind und eine Masse-Ebene vorgesehen ist.

13. Supraleitende Quanteninterferenzanordnung (SQUID) nach Anspruch 1, umfassend zwei Substrate (22), auf deren einem die erste Hochtemperatur-Supraleiterschicht (1) mit der Öffnung (3) und dem Schlitz (4) ausgebildet und auf deren anderem die zweite Hochtemperatur-Supraleiterschicht aufgebracht ist, wobei die Modulationsspule (6) und die Eingangsspule (7) aus dieser gebildet sind, und wobei die beiden Substrate (21, 22) über die dazwischenliegende erste Isolierschicht (5) dicht aufeinandergefügt sind.

14. Supraleitende Quanteninterferenzanordnung (SQUID) nach Anspruch 1, wobei die Hochtemperatur-Supraleiterschichten (1, 6, 7, 20) aus einem Gemisch einiger Oxide von Kalium K, Calcium Ca, Caesium Cs, Scandium Sc, Strontium Sr, Yttrium Y, Seltenerd-Elementen, Barium Ba, Kupfer Cu, Thallium Tl, Blei Pb und Wismut Bi bestehen.

**Revendications**

1. Interféromètre quantique supraconducteur (SQUID) comprenant :

au moins un substrat (21, 22);

une première couche supraconductrice à haute température (1) pour l'inductance supraconductrice formée sur ledit substrat (21, 22) et possédant au moins une ouverture (3), au moins une fente (4) s'étendant à partir de ladite ouverture (3) dans l'entourage de cette dernière, et deux jonctions de Josephson disposées des deux côtés de ladite fente (4);

une première couche isolante intercalaire (5) formée sur ladite première couche supraconductrice à haute température (1); et

une bobine de modulation (6) et une bobine d'entrée (7) formées au moyen du traitement d'une seconde couche supraconductrice à haute température pour le câblage formée sur ladite première couche isolante (5);

la valeur de l'inductance supraconductrice étant choisie dans une gamme comprise entre 10 et 40 pH.

2. Interféromètre quantique supraconducteur (SQUID) selon la revendication 1, dans lequel la valeur de l'inductance supraconductrice est choisie dans une gamme comprise entre 13 et 30 pH.

3. Interféromètre quantique supraconducteur (SQUID) selon la revendication 1, dans lequel ladite première couche supraconductrice à haute température (1) possède au moins une ouverture carrée (3) et la longueur d'un côté de ladite ouverture est choisie dans une gamme comprise entre 6,4 $\mu$m et 25,5 $\mu$m.

4. Interféromètre quantique supraconducteur (SQUID) selon la revendication 1, dans lequel ladite première couche supraconductrice à haute température (1) possède n (n $\geq$ 2) ouvertures (3), une fente (4) s'étendant à partir de chacune desdites ouvertures (3) et deux jonctions de Josephson (2) disposées des deux côtés de ladite fente (4), des inductances supraconductrices desdites jonctions étant branchées en parallèle.

5. Interféromètre quantique supraconducteur (SQUID) selon la revendication selon la revendication 4, dans lequel la capacité parasite est réduite par réduction de la surface de la partie située au voisinage d'une électrode, qui est située en regard desdites jonctions de Josephson (2).

6. Interféromètre quantique supraconducteur (SQUID) selon la revendication 4, dans lequel il est prévu n = 2 ouvertures, et 2 inductances supraconductrices sont branchées en parallèle.

7. Interféromètre quantique supraconducteur (SQUID) selon la revendication 4, dans lequel il est prévu n = 4 ouvertures et 4 inductances supraconductrices sont branchées en parallèle.

8. Interféromètre quantique supraconducteur (SQUID) selon la revendication 6, dans lequel l'inductance supraconductrice possède une forme de S.

9. Interféromètre quantique supraconducteur (SQUID) selon la revendication 7, dans lequel l'inductance supraconductrice recoupe une forme de S à angle droit.

10. Interféromètre quantique supraconducteur (SQUID) selon la revendication 1, dans lequel des électrodes de connexion (9) et ladite première couche supraconductrice à haute température (1) sont formées dans le même plan.

11. Interféromètre quantique supraconducteur (SQUID) selon la revendication 1, dans lequel en dehors de ladite première couche supraconductrice à haute température (1), de ladite première couche isolante (5) et de ladite seconde couche supraconductrice à haute température, au moins une autre couche supraconductrice à haute température et au moins une autre couche isolante intercalaire sont superposées, et des bornes de ladite bobine d'entrée (7) sont ressorties.

12. Interféromètre quantique supraconducteur (SQUID) selon la revendication 1, dans lequel en dehors de ladite première couche supraconductrice à haute température (1), de ladite première couche isolante (5) et de ladite seconde couche supraconductrice à haute température, au moins une autre couche supraconductrice à haute température (20) et au moins une autre couche isolante intercalaire sont superposées, et il est prévu un plan de masse.

13. Interféromètre quantique supraconducteur (SQUID) selon la revendication 1, dans lequel il est prévu deux substrats (22), sur l'un desquels ladite première couche supraconductrice à haute température (1) comportant l'ouverture (3) et la fente (4) est formée, et sur l'autre desquels ladite seconde couche supraconductrice à haute température est superposée, ladite bobine de modulation (6) et ladite bobine d'entrée (7) étant formées à partir de ces deux substrats, lesdits deux substrats (21, 22) étant appliqués étroitement l'un contre l'autre moyennant l'interposition de ladite première couche isolante (5).

**14.** Interféromètre quantique supraconducteur (SQUID) selon la revendication 1, dans lequel lesdites couches supraconductrices à haute température (1, 6, 7, 20) sont formées par un mélange de certains oxydes de potassium K, de calcium Ca, de césium Cs, de scandium Sc, de strontium Sr, d'yttrium Y, d'éléments des terres rares, de baryum Ba, de cuivre Cu, de thallium Tl, de plomb Pb et de bismuth Bi.

# F I G. IA

# F I G. IB

# F I G. IC

F I G. 2

F I G. 3

## F I G. 4

## F I G. 5

## FIG. 6A

## FIG. 6B

"S" SHAPE

# F I G. 7

F I G. 8

# FIG. 9

FIG. 10

# FIG. 11

# FIG. 12

T = 77K   $I_c = 100\mu A$

OUTPUT VOLTAGE (ARBITRARY SCALE)

INDUCTANCE (pH)